Europäisches Patentamt

European Patent Office

Office européen des brevets

(11) Veröffentlichungsnummer: **0 000 552**
A1

## (12) EUROPÄISCHE PATENTANMELDUNG

(21) Anmeldenummer: 78100453.6

(22) Anmeldetag: 20.07.78

(51) Int. Cl.²: **G 03 F 5/12**

(30) Priorität: 25.07.77 CH 9187/77

(43) Veröffentlichungstag der Anmeldung:
07.02.79 Bulletin 79/3

(84) Benannte Vertragsstaaten:
BE DE FR GB LU NL SE

(71) Anmelder: Licht Druck AG.
Claridenstrasse 36
CH-8002 Zürich. (CH)

(72) Erfinder: Müller, Hans Ernst
Höhenstrasse 5
CH-8157 Dielsdorf. (CH)

(74) Vertreter: Blum, Rudolf E. et al
c/o E. Blum & Co Patentanwälte Vorderberg 11
CH-8044 Zürich. (CH)

(54) Verfahren zum Erzeugen einer zum Herstellen einer rasterlosen Flachdruckform bestimmten photographischen Aufnahme von einer Vorlage.

(57) Bei einem Verfahren zur Erzeugung einer zum Herstellen einer rasterlosen Flachdruckform bestimmten photographischen Aufnahme von einer Vorlage, wird von der Vorlage ein Filmpositiv oder - negativ hergestellt. Ein auf einer lichtdurchlässigen Unterlage aufgebrachtes Korn wird auf ein lichempfindliches Material umkopiert, so dass eine lichtdurchlässige Kopie entsteht. Diese Kopie wird dann in den Strahlengang zwischen dem Filmpositiv oder- negativ und dem photographischen Aufnahmematerial eingesetzt. Das Aufnahmematerial wird entwickelt und es entsteht eine rasterlose photographische Aufnahme die als Druckträger verwendet wird.

Verfahren zum Erzeugen einer zum Herstellen
einer rasterlosen Flachdruckform bestimmten
photographischen Aufnahme von einer Vorlage

Die vorliegende Erfindung betrifft ein Verfahren zum Erzeugen einer zum Herstellen einer Flachdruckform
bestimmten photographischen Aufnahme von einer Vorlage und
eignet sich vorzugsweise zum Herstellen von Offsetdruckformen.

Bekanntlich ist es beim Offsetdruckverfahren
für die Wiedergabe von Halbtönen notwendig, eine Aufteilung
in Rasterpunkte vorzunehmen. Diese Aufteilung in Rasterpunkte
erfolgt in bekannter Weise mittels Gravur- oder Kontaktrastern,
die beim Anfertigen einer photographischen Aufnahme der Vorlage das lichtempfindliche Aufnahmematerial geschaltet werden. Diese Aufnahme wird zur Herstellung einer Offsetdruckplatte verwendet. Die Anwendung solcher konventioneller Rasteraufnahmen wird zur Herstellung aller üblichen Druckerzeugnisse
angewandt, wobei durch den Raster feine Detailzeichnungen zu
wenig genau wiedergegeben werden können.

Unter der Bezeichnung "Lichtdruck" ist ein
weiteres Verfahren bekannt, das ohne Verwendung eines Rasters
für Grautöne arbeitet. Hierbei wird eine photoempfindliche
Gelatineschicht durch auffallendes Licht fortschreitend gehärtet. Da die Gelatineschicht mechanisch wenig stabil ist,
können mit solchen Platten nur kleine Auflagen mit geringer
Geschwindigkeit gedruckt werden. Ferner kann sich die Wasseraufnahme der Gelatine während des Druckvorganges verändern,
so dass Farbwertverschiebungen auftreten können.

Zweck der Erfindung ist diese Nachteile zu
beheben.

Die Erfindung, wie sie in den Ansprüchen gekennzeichnet ist, löst die Aufgabe ein Verfahren zum Erzeugen
einer zur Herstellung einer rasterlosen Flachdruckform bestimmten photographischen Aufnahme von einer Vorlage zu schaffen,

0000552

bei dem ohne Verwendung eines Rasters von einer Vorlage eine Flachdruckform erzeugt werden kann, mit der Drücke grosser Originaltreue hergestellt werden können.

Die durch die Erfindung erreichten Vorteile sind im wesentlichen darin zu sehen, dass die Moiré-Bildung wegen der wegfallenden Rasterdrehung nicht auftritt und somit mehr als sechs Farben gedruckt werden können, und dass der Halbton direkt auf die Platte, die als Druckträger verwendet wird, kopiert wird. Es ergibt sich eine feinere Auflösung als beim Lichtdruckverfahren und es können grössere Auflagen bei höheren Druckgeschwindigkeiten gedruckt werden.

Von der zu druckenden Vorlage wird ein Filmpositiv oder -negativ auf bereits bekannte Weise hergestellt. Im Gegensatz zu den herkömmlichen Verfahren wird jedoch anstelle eines Rasters eine lichtdurchlässige Kopie des Kornes eines feinkörnigen Materials in den Strahlengang zwischen das Filmpositiv oder -negativ und das photographische Aufnahmematerial geschaltet. Von der Vorlage wird auf bekannte Weise, z.B. mittels des Kontaktkopierverfahrens, durch diese Kopie des Kornes des feinkörnigen Materials hindurch auf dem photographischen Aufnahmematerial eine Aufnahme hergestellt.

Zum Erzeugen der erwähnten Kopie wird auf eine lichtdurchlässige Unterlage, beispielsweise eine Glasplatte, ein feinkörniges Material wie Asphalt, Dispersion, Staubpuder, aufgebracht. Vorzugsweise wird als feinkörniges Material Asphalt verwendet, wie er bereits beim bekannten Photochrom-Verfahren Anwendung findet. Das Korn des feinkörnigen Materials, bzw. des Asphalts, wird auf ein lichtempfindliches Material, beispielsweise auf Film, umkopiert. Dieses Umkopieren erfolgt vorteilhafterweise nach dem Kontaktkopierverfahren.

Von der auf die beschriebene Weise erzeugten photographischen Negativ- oder Positiv-Aufnahme der Vorlage wird nun auf herkömmliche Weise die Flachdruckform, beispielsweise Offsetdruckplatte, hergestellt.

Die Verwendung der beschriebenen Kopie des

Kornes von Asphalt oder eines anderen geeigneten feinkörnigen Materials erlaubt die Herstellung einer Druckform, die eine genaue und tonwertrichtige Wiedergabe einer Vorlage ermöglicht. Das erfindungsgemässe Verfahren eignet sich daher besonders für die Herstellung von Faksimiledrucken, bei denen die exakte und feine Wiedergabe der Detailzeichnung der Vorlage von Wichtigkeit ist.

—

- 1 -

P a t e n t a n s p r ü c h e

1. Verfahren zum Erzeugen einer zum Herstellen einer Flachdruckform bestimmten photographischen Aufnahme von einer Vorlage, dadurch gekennzeichnet, dass von einer Vorlage ein Filmpositiv oder -negativ hergestellt wird, dass das Korn eines auf einer lichdurchlässigen Unterlage aufgebrachten feinkörnigen Materials auf ein lichtempfindliches Material umkopiert wird und dass die auf diese Weise erhaltene lichtdurchlässige Kopie zur Herstellung der photographischen Aufnahme in den Strahlengang zwischen Filmpositiv oder -negativ und photographischen Aufnahmematerial eingesetzt wird.

2. Verfahren nach Anspruch 1, dadurch gekennzeichnet, dass als feinkörniges Material Asphalt, Dispersion oder Staubpuder verwendet wird.

3. Verfahren nach einem der Ansprüche 1 oder 2, dadurch gekennzeichnet, dass als lichtdurchlässige Unterlage eine  Glasplatte verwendet wird.

4. Verfahren nach einem der Ansprüche 1 oder 2, dadurch gekennzeichnet, dass das Korn des feinkörnigen Materials mittels eines Kontaktkopierverfahrens auf das lichtempfindliche Material umkopiert wird.

5. Verfahren nach Anspruch 1, dadurch gekennzeichnet, dass als lichtempfindliches Material ein Film oder Platte verwendet wird.

18.7.1978                                                    EU 1006

0000552

6. Verfahren nach Anspruch 1, dadurch gekennzeichnet, dass bei der Herstellung der photographischen Aufnahme sich die Kopie des Kornes des feinkörnigen Materials und das photographische Aufnahmematerial in engem Kontakt miteinander befinden.

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | FR - A - 2 026 473 (RAPOPORT PRINTING) <br><br> * Patentansprüche 1,8-10; Seite 3, Zeile 27 bis Seite 4, Zeile 10; Seite 4, Zeilen 30-33; Seite 6, Zeile 32 bis Seite 7, Zeile 13; Abbildung * | 1-6 |
| | FR - A - 1 475 816 (C.WELTER) <br><br> * "Résumé"; Seite 1, rechte Spalte, letzter Absatz bis Seite 2, linke Spalte, Zeile 2 und Zeile 27 bis rechte Spalte, letzter Absatz; Abbildung 2 * | 1-6 |
| | US - A - 1 948 604 (H.WEIL) <br><br> * Patentanspruch 1 * | 1,6 |
| | FR - A - 481 156 (G.NAHRATH) <br><br> * "Résumé" * | 2,3 |

**KLASSIFIKATION DER ANMELDUNG (Int.Cl.²)**

G 03 F 5/12

**RECHERCHIERTE SACHGEBIETE (Int. Cl.²)**

G 03 F 5/12

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 20-10-1978 | PHILOSOPH |